Europäisches Patentamt

European Patent Office

Office européen des brevets

(19)

(11) Veröffentlichungsnummer: **0 095 469**
**B1**

(12) **EUROPÄISCHE PATENTSCHRIFT**

(45) Veröffentlichungstag der Patentschrift:
09.04.86

(51) Int. Cl.⁴: **B 43 L 13/02, G 06 K 15/22**

(21) Anmeldenummer: **82903443.8**

(22) Anmeldetag: **01.12.82**

(86) Internationale Anmeldenummer:
**PCT/CH 82/00124**

(87) Internationale Veröffentlichungsnummer:
**WO 83/01927** (09.06.83 Gazette 83/14)

(54) **LICHT-SCHREIBKOPF ZUM BELICHTEN VON PUNKTEN ODER BAHNEN AUF EINEM RELATIV BEWEGBAREN PHOTOGRAPHISCHEN TRÄGER.**

(30) Priorität: 03.12.81 CH 7740/81
22.07.82 CH 4497/82

(43) Veröffentlichungstag der Anmeldung:
07.12.83 Patentblatt 83/49

(45) Bekanntmachung des Hinweises auf die Patenterteilung:
09.04.86 Patentblatt 86/15

(84) Benannte Vertragsstaaten:
AT CH DE FR GB LI

(56) Entgegenhaltungen:
CH - A - 492 572
FR - A - 2 048 667
GB - A - 1 154 441
US - A - 3 043 189
US - A - 3 143 940

(73) Patentinhaber: GLASER, Roland, Wildsbergstrasse 28,
CH-8600 Greifensee (CH)

(72) Erfinder: GLASER, Roland, Wildsbergstrasse 28,
CH-8600 Greifensee (CH)

(74) Vertreter: Haffter, Tobias Fred, Dr. Dipl.-Phys. et al,
PATENTANWALTS-BUREAU ISLER AG
Postfach 6940 Walchestrasse 23, CH-8023 Zürich (CH)

## Beschreibung

Ein Lichschreibkopf gemäss Oberbegriff des Anspruchs 1 ist aus der GB-A-1 154 441 bekannt. Dieser Schreibkopf wird zur Erzeugung eines Strichmusters geradlinig fortbewegt. Quer zur Fortschrittsrichtung ist im Boden des Gehäuses ein Schlitz angeordnet, der durch eine Anzahl sich gegenseitig überlappender Verschlussglieder abgedeckt ist. Der Schlitz wird von oben durch eine Lichtquelle beleuchtet. Zur Erzeugung eines Striches wird eines der Verschlussglieder geöffnet, wodurch eine Lichtaustrittsöffnung gebildet wird, welche vorn und hinten durch die beiden Ränder des Schlitzes, seitlich durch je eines der geschlossenen Verschlussglieder begrenzt ist. Die Verschlussglieder sind wegen der erforderlichen Ueberlappung in verschiedenen Ebenen oberhalb des Schlitzes angeordnet. Da das Licht von der Lichtwuelle nicht parallel auf die Lichtaustrittsöffnung auftrifft, werden wegen der unterschiedlichen Abstände der Ränder der Lichtaustrittöffnung von der photographischen Schicht die Ränder der erzeugten Striche unscharf.

Die Erfindung bezweckt die Beseitigung dieses Nachteils unter Beibehaltung der aus der GB-A-1 154 441 bekannten Lösung ohne abbildendes Linsensystem.

Diese Aufgabe wird durch die kennzeichnenden Merkmale der Ansprüche 1 und 9 gelöst.

Aus der CH-A-492 572 ist es an sich bekannt, bei einem Licht-Schreibkopf ein lichtdichtes Gehäuse zu verwenden. Dieser Schreibkopf verwendet allerdings ein aufwendiges abbildendes Linsensystem.

Ueberraschenderweise hat es sich erwiesen, dass mit dem erfindungsgemässen Belichtungssystem sich trotz dessen einfacher Ausbildung die Auflösungs- und Aufzeichnungserfordernisse ohne weiteres erreichen lassen. Zudem hat es sich gezeigt, dass der jeweilige Abstand zwischen der lichtempfindlichen Schicht des photographischen Trägers und der Lichtaustrittsöffnung in der Bodenwand des Gehäuses in einem verhältnismässig weiten Bereich von einem minimalen Wert der Berührung bis zu einem Wert von etwa 2 mm ohne..............

Einfluss auf die Aufzeichnungsgenauigkeit ist. Allgemein ist zu bemerken, dass dann, wenn das Licht aus der das Lichtbündel begrenzenden Oeffnung mindestens angenähert parallel austritt, sich die Lichtaustrittsöffnung in einem Abstand von der lichtempfindlichen Schicht befinden kann. Bei nichtparallelem Lichtaustritt soll die lichtbündelbegrenzende Lichtaustrittsöffnung jedoch direkt auf der lichtempfindlichen Schicht des photographischen Trägers liegen.

Der erfindungsgemässe Licht-Schreibkopf ist insbesondere zur Herstellung transparenter Leiterplatten-Matrizen auf einem photographischen Film oder einer photographischen Glasplatte geeignet, d.h. zur Herstellung einer Mutter- oder Stammfolie bzw. -platte, welche später als Belichtungsvorlage zur massenweisen Herstellung von Leiterplatten (gedruckten Schaltungen) mit dem gleichen Leitungsmuster dient.

Ausführungsbeispiele des Erfindungsgegenstandes werden nachstehend anhand der Zeichnungen erläutert, welche in den

Fig. 1 bis 3 je einen senkrechten Schnitt durch einen über einem photographischen Film angeordneten Licht-Schreibkopf zeigen, nämlich:

in Fig. 1 einen Licht-Schreibkopf mit einer Bildmaske,

in Fig. 2 einen Licht-Schreibkopf mit einem Lichtleiter, und

in Fig. 3 einen Licht-Schreibkopf mit einer Oeffnung in einem Bodenvorsprung.

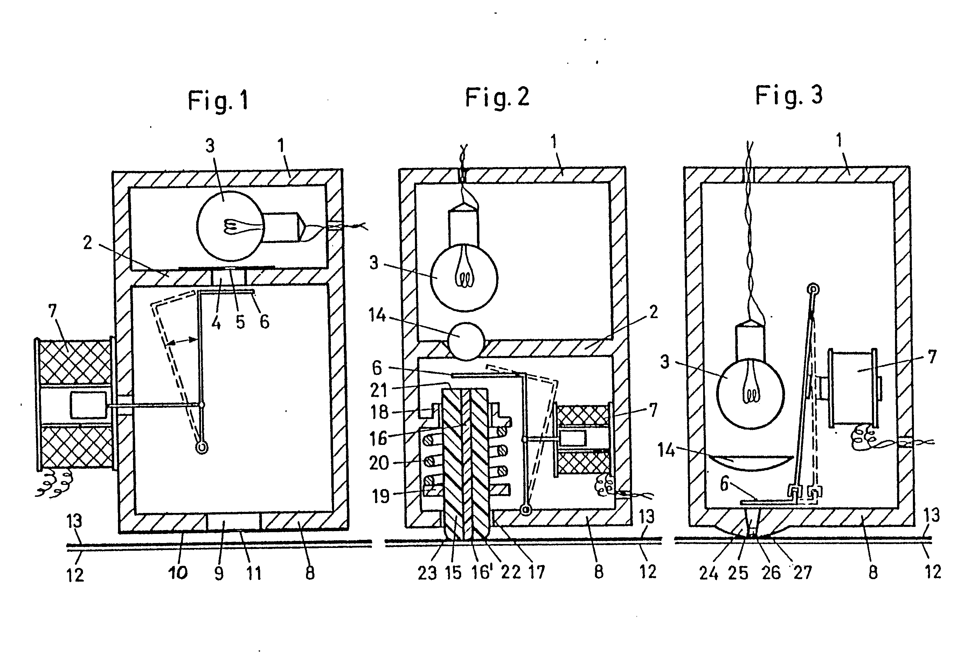

Der in Fig. 1 dargestellte Schreibkopf weist ein kastenförmiges Gehäuse 1 auf, das lichtdicht ist und dessen Innenseite zur Vermeidung von Lichtreflexionen matt geschwärzt ist. Oberhalb einer waagrechten Trennwand 2 ist als Lichtquelle eine elektrische Glühlampe 3 mit einer Stärke von beispielsweise 5W untergebracht. Durch eine Oeffnung 4, welche durch eine Lochblende 5 abgedeckt ist, gelangt Licht in den unterhalb der Trennwand 2 befindlichen Innenraum des Gehäuses 1. Unterhalb der Oeffnung 4 ist ein mechanischer Verschluss 6 angeordnet, der aus seiner ausgezogen dargestellten Schliesslage mittels eines Elektromagneten 7 in eine gestrichelt dargestellte Oeffnungslage, und umgekehrt, bringbar ist.

Eine Bodenwand 8 des Gehäuses 1 weist eine Oeffnung 9 auf, über welcher eine an der Aussenfläche der Bodenwand 8 angeordnete Bildmaske 10 liegt. Die Bildmaske 10 besteht beispielsweise aus einer Metallfolie oder einem Film und sperrt den Lichtdurchgang durch die Oeffnung 9 bis auf einen kleinen lichtdurchlässigen Bereich 11, der beispielsweise kreisförmig ist.

Bei eingeschalteter Glühlampe 3 und geöffnetem Verschluss 6 wird demnach der Glühfaden der Glühlampe 3 bzw. seine Leuchtfläche auf die Oeffnung 9 der Bodenwand 8 und damit auf den lichtdurchlässigen Bereich 11 der Bildmaske 10 abgebildet und beleuchtet diesen Bereich. Die lichtempfindliche Schicht 13 eines unmittelbar unterhalb der Bildmaske 10 befindlichen photographischen Trägers 12, z.B. eines photographischen Films oder einer photographischen Glasplatte, wird somit mit dem Bild des lichtdurchlässigen Bereichs 11 der Bildmaske 10 belichtet, so dass der auf dem photographischen Träger belichtete Bereich bezüglich Form und Grösse dem lichtdurchlässigen Bereich 11 der Bildmaske 10 entspricht.

Zur Belichtung von Punkten, Bahnen, Figuren und Flächen beliebiger Gestalt auf dem photographischen Träger 12 wird der vorliegende Licht-Schreibkopf am Arbeitswagen einer Zeichenmaschine oder eines Koordinatentisches derart befestigt, dass der Abstand zwischen der Unterseite der Bildmaske 10 und dem photographischen, auf dem Tisch der Zeichenmaschine bzw. dem Koordinatentisch etwa 1 mm beträgt. Es hat sich gezeigt, dass dieser Abstand bezüglich einer scharfen, konturengerechten Abbildung des lichtdurchlässigen Bereichs 11 der Bildmaske 10 auf die lichtempfindliche Schicht 13 des photograpbischen Trägers 12 keineswegs kritisch ist und im Bereich von wenig mehr als 0 mm bis etwa 2 mm liegen kann. Sollte also der photographische Träger 12 an seiner Belichtungsstelle nicht absolut plan aufliegen, so ist die Abbildungstreue gewahrt, ohne dass hierfür wie bei eingangs erwähnten bekannten Einrichtungen eine Abstandsregelung oder dgl. erforderlich wäre.

Vorzugsweise erfolgen die Steuerung der Bewegung des Arbeitswagens in zwei Koordinatenrichtungen sowie die Steuerung des Verschlusses 6 vollautomatisch durch einen Computer wobei Bahnen mit grösserer Breite als der Durchmesser des lichtdurchlässigen Bereichs 11 der Bildmaske 10 durch mehrfaches Belichten in jeweils versetzter Lage erzeugt werden. Es ist auch möglich, eine Bildmaske 10 mit mehreren lichtdurchlässigen Bereichen 11 unterschiedlicher Grösse und/oder Form vorzusehen. Um wahlweise den photographischen Träger mittels eines dieser lichtdurchlässigen Bereiche zu belichten, kann die Bildmaske 10 an der Bodenwand 8 verschiebbar angeordnet sein, wo eine ebenfalls durch den Computer gesteuerte Antriebsvorrichtung der verschiebbaren Bildmaske jeweils den nach Programm erforderlichen lichtdurchlässigen Bereich in das Licht der Glühlampe 3 bringt. Andererseits können auch im Gehäuse mehrere Glühlampen 3 samt zugehörigen Lochblenden 5 und Verschlüssen 6 voneinander lichtgetrennt angeordnet werden, wobei jeder Glühlampe einer von mehreren lichtdurchlässigen Bereichen einer festen Bildmaske zugeordnet ist. Zur Erzielung einer gleichmässigen Belichtung der lichtempfindlichen Schicht 13 des photographischen Trägers 12 kann die Helligkeit der bzw. jeder Glühlampe 3 in an sich bekannter Weise in Abhängigkeit von der jeweiligen relativen Vorschubgeschwindigkeit des Licht-Schreibkopfs bezüglich des photographischen Trägers gesteuert werden, vorzugsweise ebenfalls durch den genannten Computer.

Der in Fig. 2 dargestellte Schreibkopf weist wiederum ein kastenförmiges Gehäuse 1 auf, das lichtdicht ist. Oberhalb der waagrechten Trennwand 2 ist als Lichtquelle ebenfalls eine elektrische Glühlampe 3 mit einer Stärke von beispielsweise 5W untergebracht. Durch eine zur Verminderung von Lichtverlusten in die Trennwand 2 eingelassene Sammellinse 14 gelang Licht in den unterhalb der Trennwand 2 befindlichen Innenraum des Gehäuses 1. Unterhalb der Oeffnung 4 ist wie beim Ausführungsbeispiel der Fig. 1 ein mechanischer Verschluss 6 angeordnet, der aus seiner ausgezogen dargestellten Schliesslage mittels eines im Gehäuse 1 angeordneten Elektromagneten 7 in eine gestrichelt dargestellte Oeffnungslage, und umgekehrt, bringbar ist.

In der durch die Glühlampe 3 und die Sammellinse 14 gebildeten optischen Achse ist ein in einem beispielsweise zylindrischen Halter 15 eingebetteter Lichtleiter 16 angeordnet. Der Halter 15, der aus einem Kunststoff, z.B. aus einem ausgehärteten Epoxyharz, bestehen kann, ist in einer Oeffnung 17 der Bodenwand 8 des Gehäuses 1 sowie in einer Führung 18 des Gehäuses 1 in axialer Richtung beweglich gelagert und steht über die Aussenfläche der Bodenwand 8 vor. Eine sich einerseits auf die Führung 18 und andererseits auf einen am Halter 15 angebrachten Ring 19 abstützende Druckfeder 20 übt auf den Halter 15 eine nach dem Gehäuseäussern gerichtete axiale Kraft aus. Der Halter 15 und der darin eingebettete Lichtleiter 16 haben eine obere Stirnfläche 21 und eine untere ebene, glatte Stirnfläche 22 bzw. 16'. Insbesondere die unteren Stirnflächen 16' und 22 sind möglichst glatt, was sich in an sich bekannter Weise durch Polieren, Läppen usw. erzielen lässt. Zudem ist der Rand 23 des Halters 15 abgerundet. Der Lichtleiter 16 kann in an sich bekannter Weise eine Lichtleitfaser oder ein Lichtleiter grösseren Durchmessers sein.

Zur Belichtung von Punkten, Bahnen, Figuren und Flächen beliebiger Gestalt auf der lichtempfindlichen Schicht 13 des photographischen Trägers 12, z.B. einem photographischen Film oder einer photographischen Glasplatte, wird der vorliegende Licht-Schreibkopf bzw. dessen Gehäuse 1 am Arbeitswagen einer Zeichenmaschine oder eines Koordinatentisches befestigt. Hierbei erfolgt die Anordnung derart, dass der Halter 15 mit seiner unteren Stirnfläche 22 und damit auch mit der Stirnfläche 16' des Lichtleiters 16 unter der Kraft der Feder 20 auf die lichtempfindliche Schicht 13 des photographischen Trägers 12 drückt. Zufolge der vorgängig genannten Oberflächenbehandlung der Stirnflächen 16' und 22 ist eine Beschädigung der lichtempfindlichen Schicht 13 bei einer Verschiebebewegung des Gehäuses 1 parallel zur Ebene des photographischen Trägers 12 ausgeschlossen. Der photographische Träger 12 braucht auf der Zeichenmaschine bzw. auf dem Koordinatentisch nicht absolut plan aufzuliegen, da die Feder 20 den Kontakt der Stirnflächen 22 und 16' des Halters 15 bzw. des Lichtleiters 16 mit der lichtempfindlichen Schicht 13 des photographischen Trägers 12 aufrechterhält. Es ist von Vorteil, Mittel vorzusehen, mit welchen die Kraft der Feder 20 eingestellt werden kann, beispielsweise indem der Ring 19 als Gewindering ausgebildet und der Halter 15 mit einem entsprechenden Aussengewinde versehen wird.

Bei eingeschalteter Glühlampe 3 und erregtem Elektromagneten 7, d.h. geöffnetem Verschluss 6, gelangt das durch die Sammellinse 14 gesammelte Licht der Glühlampe 3 auf die obere Stirnfläche 21 des Lichtleiters 16 und wird durch den Lichtleiter 16 geführt, um an dessen unteren Stirnfläche 16' wieder auszutreten. Der Lichtaustritt erfolgt an sich divergent. Da jedoch die untere Stirnfläche 16' des Lichtleiters 16 die lichtempfindliche Schicht 13 des photographischen Trägers 12 dauernd berührt, wird auf der lichtempfindlichen Schicht 13 ein exaktes Bild der an der Stirnfläche 16' erscheinenden Querschnittsform des Lichtleiters 16 erzeugt.

Hierbei kann das auf dem photographischen Träger 12 erzeugte Bild bezüglich der Querschnittsform des Lichtleiters 16 dadurch modifiziert werden, dass die untere Stirnfläche 16' des Lichtleiters 16 mit einer Bildmaske versehen wird, die einen Teil des Querschnitts des Lichtleiters 16 abdeckt. Eine solche Bildmaske wird als dünne Abdeckschicht ausgebildet, damit sie ohne Beschädigung der lichtempfindlichen Schicht 13 des photographischen Trägers 12 auf dieser aufliegen kann und nur einen vernachlässigbar kleinen Abstand zwischen der Stirnfläche 16' des Lichtleiters 16 und der lichtempfindlichen Schicht 13 des photographischen Trägers 12 zur Folge hat.

Das auf dem photographischen Träger 12 erzeugte Bild kann bezüglich der Querschnittsform des Lichtleiters 16 auch dadurch modifiziert werden, dass die obere Stirnfläche 21 des Lichtleiters 16 mit einer Bildmaske versehen ist, die einen Teil des Querschnitts des Lichtleiters 16 abdeckt. Damit jedoch in diesem Fall auf dem photographischen Träger 12 ein treues Bild der Bildmaske entsteht, muss der Lichtleiter geordnet sein, d.h. jede Faser eines den Lichtleiter bildenden Faserbündels muss an der Lichteintrittsfläche und Lichtaustrittsfläche gleiche Nachbarfasern haben.

Im übrigen ist die Lichtausbeute beim Ausführungsbeispiel der Fig. 2 relativ hoch, da das Licht der Glühlampe 3 in einfacher Weise auf den Lichtleiter 16 gebündelt werden kann und sich in diesem gebündelt fortpflanzt.

Die Länge des Lichtleiters 16 ist ohne Bedeutung für die Erzeugung des genannten Bildes auf der lichtempfindlichen Schicht 13 des photographischen Trägers 12. Einerseits kann die Länge bei geeigneter mechanischer Konstruktion des Halters 15 extrem klein sein und z.B. nur einen Millimeter betragen. Andererseits kann der Lichtleiter 16 auch eine sehr grosse Länge haben, von der nur ein kleinerer Teil im Halter 15 eingebettet ist. Der grössere Teil des Lichtleiters kann, insbesondere wenn dieser flexible ausgebildet ist, durch eine der Wände des Gehäuses I hindurch nach aussen und zu einer externen, z.B. in einem stationären Gehäuse untergebrachten Lichtquelle geführt werden. Hierbei ist es möglich, mittels einer Lichtleiterkupplung bekannter Bauart den im Gehäuse 1 befindlichen Teil des Lichtleiters von dem ausserhalb des Gehäuses 1 befindlichen Teil trennbar anzuordnen.

Vorzugsweise erfolgen die Steuerung der Bewegung des Arbeitswagens in zwei Koordinatenrichtungen sowie die Steuerung des Verschlusses 6 vollautomatisch durch einen Computer. Hierbei können Bahnen mit grösserer Breite als der Durchmesser des verwendeten Lichtleiters 16 oder auch komplexere Figuren durch mehrfaches Belichten in jeweils versetzter Lage erzeugt werden. Dabei kann eine Wahlmöglichkeit für die minimale Ausgangsbahnenbreite dadurch geschaffen werden, dass der Halter 15 mit dem eingebetteten Lichtleiter 16 im Gehäuse 1 auswechselbar angeordnet wird, so dass dann jeweils einer von mehreren Haltern mit Lichtleitern unterschiedlicher Querabmessungen bzw. Austrittsöffnungen in das Gehäuse eingesetzt werden kann.

Der in Fig. 3 dargestellte Schreibkopf weist ebenfalls ein kastenförmiges Gehäuse 1 auf, das lichtdicht ist und in welchem als Lichtquelle eine Glühlampe 3 untergebracht ist. Die Bodenwand 8 des Gehäuses 1 weist einen äusseren Bodenvorsprung 24 auf, welcher mit einer durchgehenden Oeffnung 25 mit einem bestimmten Durchmesser versehen ist. Das Licht der Glühlampe 3 wird zur Verminderung von Lichtverlusten durch die Sammellinse 14 konzentriert und fällt auf die durch den mechanischen Verschluss 6 abdeckbare Oeffnung 25 und damit auf die lichtempfindliche Schicht 13 des photographischen Trägers 12. Wie bei den Ausführungsbeispielen der Fig. 1 und 2 ist der mechanische Verschluss 6 aus seiner ausgezogen dargestellten Schliesslage mittels des Elektromagneten 7 in die gestrichelt dargestellte Oeffnungslage, und umgekehrt, bringbar.

Der Bodenvorsprung 24 ist dazu vorgesehen, in direkte Berührung mit der lichtempfindlichen Schicht 13 des photographischen Trägers 12 gebracht zu werden. Um eine Beschädigung der lichtempfindlichen Schicht 13 durch den scharfkantigenäusseren Rand der Oeffnung 25 zu vermeiden, ist in die Oeffnung 25 ein lichtdurchlässiges Füllstück 26 eingesetzt, z.B. ein. Glasstück. Die äussere Fläche des Füllstücks 26 ist mit der im übrigen abgerundeten Aussenfläche 27 des Bodenvorsprungs 24 bündig und glatt bearbeitet, z.B. poliert oder geläppt.

Die Arbeitsweise des in Fig. 3 dargestellten Schreibkopfs ist gleich wie beim Ausführungsbeispiel der Fig. 2 bezüglich der dauernden Berührung zwischen der Oeffnung 24 und der lichtempfindlichen Schicht 13 und dem durch die Querschnittsform der Oeffnung 24 in der Aussenfläche 27 des Bodenvorsprungs 24 bestimmten Bild auf der lichtempfindlichen Schicht 13. Bezüglich Relativbewegung zwischen dem Gehäuse 1 und dem photographischen Träger 12 sowie bezüglich der Betätigung des Verschlusses 6 zur Belichtung von Punkten, Bahnen, Figuren und Flächen ist die Arbeitsweise des Schreibkopfs der Fig. 3 gleich wie diejenige, die vorgängig für die Ausführungsbeispiele der Fig. 1 und 2 beschrieben worden ist.

In den beschriebenen Ausführungsbeispielen des Licht-Schreibkopfs ist als Lichtquelle eine Glühlampe vorgesehen. Es versteht sich, dass auch Lichtquellen anderen Typs bei geeigneten äusseren Abmessungen Verwendung finden können, z.B. eine Halbleitervorrichtung, eine Laservorrichtung, eine Gasentladungsvorrichtung oder dergleichen.

Anstelle der dargestellten und beschriebenen elektromagnetischen Betätigung des mechanischen Verschlusses 6 mit Hilfe des Elektromagneten 7 kann auch eine piezoelektrische Betätigung vorgesehen werden. Des weitern kann auf die Anordnung eines mechanischen Verschlusses zur Lichtsteuerung verzichtet werden, indem stattdessen die Lichtquelle getastet wird, beispielsweise durch den vorerwähnten, zur Steuerung der Bewegung des Arbeitswagens vorgesehenen Computer. Eine solche Tastung der Lichtquelle ist insbesondere dann problemlos möglich, wenn eine Lichtquelle ohne Glühfaden verwendet wird, also zum Beispiel eine Halbleiter-Lichtquelle, deren Einund Ausschaltung praktisch verzögerungsfrei erfolgen kann. Darüberhinaus besteht für das Ausführungsbeispiel der Fig. 2 eine Variante der Lichtsteuerung darin, anstelle eines mechanischen Verschlusses bzw. einer Austastung der Lichtquelle den von der Lichtquelle gespeisten Lichtpfad im Lichtleiter durch eine gesteuerte Veränderung des Brechungsindexes des Lichtleiters zu unterbrechen. Optische Schalter mit einem Lichtleiter, die elektromagnetisch oder piezoelektrisch, insbesondere durch Deformation des Lichtleiters, betätigt werden können, sind an sich bekannt. Bei einer nicht dargestellten Variante kann das Gehäuse des Licht-Schreibkopfs hülsenförmig statt kastenförmig sein. Der Schreibkopf kann dann insbesondere die Form und Abmessungen eines üblichen Tinten-Schreibstifts für Zeichenmaschinen oder Koordinatographen aufweisen und dadurch in einfacher Weise anstelle eines solchen Schreibstifts mittels des vorgesehenen Halters in die Zeichenmaschine oder den Koordinatographen eingesetzt werden.

Statt den zu belichtenden photographischen Film auf einer ebenen Platte einer Zeichenmaschine oder eines Koordinatentisches anzuordnen, kann er auch auf einer drehbaren Trommel aufgespannt werden, so dass dann der Licht-Schreibkopf nur in einer Koordinatenrichtung parallel zur Trommelachse zu bewegen ist.

**Patentansprüche**

1. Licht-Schreibkopf zum Belichten von Punkten oder Bahnen auf einem photographischen Träger (12) in einer Zeichenmaschine oder auf einem Koordinatentisch, welche Mittel zur Erzeugung einer automatisch gesteuerten Relativbewegung zwischen dem Schreibkopf und dem photographischen Träger (12) aufweisen, wobei in einem Gehäuse (1) eine steuerbare Beleuchtungseinrichtung (3,6,7;3,6,7,16) angeordnet ist und das Gehäuse (1) eine von der Beleuchtungseinrichtung (3,6,7; 3,6,7,16) beleuchtete Lichtaustrittsöffnung (11;16',25) aufweist, welche mindestens angenähert in Berührung mit einer lichtempfindlichen Schicht (13) des photographischen Trägers (12) bringbar ist und welche den zu belichtenden Punkten bzw. Bahnen entsprechende Querabmessungen hat, dadurch gekennzeichnet, dass die Lichtaustrittsöffnung (11) in einer einzigen Ebene an der äusseren Fläche einer Bodenwand (8) des lichtdichten Gehäuses (1) angeordnet ist, dass die Lichtquelle (3) der Beleuchtungseinrichtung (3,6,7) in einer durch eine Trennwand (2) abgeschlossenen Kammer des Gehäuses (1) angeordnet ist, und dass die Trennwand (2) eine Lochblende (5) aufweist.

2. Licht-Schreibkopf nach Anspruch 1, dadurch gekennzeichnet, dass die Bodenwand (8) mit einer von der Lichtquelle (3) beleuchteten Bildmaske (10) versehen ist.

3. Licht-Schreibkopf nach Anspruch 2, dadurch gekennzeichnet, dass die Bildmaske (10) eine mit einem lichtdurchlässigen Bereich (11) versehene Folie ist, z.B. eine Metallfolie oder ein Film.

4. Licht-Schreibkopf nach einem der Ansprüche 1 bis 3, dadurch gekennzeichnet, dass der Lochblende (5) ein elektrisch sttuerbarer, z.B. elektromagnetisch oder piezoelektrisch betätigbarer Verschluss (6) zugeordnet ist.

5. Licht-Schreibkopf nach Anspruch 2, dadurch gekennzeichnet, dass zur Steuerung der Beleuchtung der Bildmaske (10) Mittel zur Tastung der Lichtquelle vorhanden sind.

6. Licht-Schreibkopf nach Anspruch 2, dadurch gekennzeichnet, dass die Bildmaske (10) mehrere lichtdurchlässige Bereiche unterschiedlicher Form und/oder Grösse aufweist, und dass Mittel vorgesehen sind, um wahlweise einen der lichtdurchlässigen Bereiche in das Lichtbündel der Lichtquelle (3) zu bringen.

7. Licht-Schreibkopf nach Anspruch 6, dadurch gekennzeichnet, dass die Bildmaske (10) verschiebbar an der Bodenfläche des (1) Gehäuses angeordnet ist.

8. Licht-Schreibkopf nach Anspruch 6, dadurch gekennzeichnet, dass das Gehäuse (1) mehrere Lichtquellen enthält, von welchen jede einem der lichtdurchlässigen Bereiche der Bildmaske (10) zugeordnet ist.

9. Licht-Schreibkopf nach dem Oberbegriff des Anspruchs 1, dadurch gekennzeichnet, dass die Lichtaustrittsöffnung (16',25) in einer einzigen Ebene an der Stirnseite eines zum Aufliegen auf der lichtempfindlichen Schicht (13) des photographischen Trägers (12) ausgebildeten Bauteils (15,24) angeordnet ist, und dass das Gehäuse (1) lichtdicht ist.

10. Licht-Schreibkopf nach Anspruch 9, dadurch gekennzeichnet, dass im Gehäuse (1) mindestens ein Lichtleiter (16) angeordnet ist, dessen eine Stirnfläche (21) durch eine Lichtquelle (3) beleuchtet ist und der mit seinem die andere Stirnfläche (16') aufweisenden Ende über die Bodenwand (8) des Gehäuses (1) hinausragt, wobei die zweitgenannte Stirnfläche (16') zum Aufliegen auf der lichtempfindlichen Schicht (13) des photographischen Trägers (12) ausgebildet ist.

11. Licht-Schreibkopf nach Anspruch 10, dadurch gekennzeichnet, dass der Lichtleiter (16) in einem den Bauteil bildenden Halter (15) eingebettet ist, welcher im Gehäuse (1) in Längsrichtung des Lichtleiters (16) beweglich gelagert ist.

12. Licht-Schreibkopf nach Anspruch 11, dadurch gekennzeichnet, dass der Lichtleiter (16) zusammen mit dem Halter (15) durch eine Oeffnung (17) der Bodenwand (8) ragt und zusammen mit dem Halter (15) eine gemeinsame ebene und glatte Stirnfläche (16',22) bildet.

13. Licht-Schreibkopf nach Anspruch 11 oder 12, dadurch gekennzeichnet, dass die Lagerung des Halters (15) eine Führung (18) und eine den Halter (15) nach der Aussenseite des Gehäuses (1) drückende Feder (20) umfasst.

14. Licht-Schreibkopf nach Anspruch 10, dadurch gekennzeichnet, dass die erstgenannte Stirnfläche (21) des Lichtleiters (16) im Innern des Gehäuses (1) liegt und von einer ebenfalls im Innern des Gehäuses (1) angeordneten Lichtquelle (3) über eine Sammellinse (14) beleuchtbar ist.

15. Licht-Schreibkopf nach Anspruch 14, dadurch gekennzeichnet, dass zwischen der Lichtquelle (3) und der Stirnfläche (21) des Lichtleiters (16) ein elektrisch steuerbarer, z.B. elektromagnetisch oder piezoelektrisch betätigbarer Verschluss (6) angeordnet ist.

16. Licht-Schreibkopf nach Anspruch 10, dadurch gekennzeichnet, dass die Lichtquelle (3) ausserhalb des Gehäuses (1) ortsfest angeordnet ist, und dass der sich ausserhalb des Gehäuses (1) bis zur Lichtquelle (3) erstreckende Lichtleiter (16) flexibel ist.

17. Licht-Schreibkopf nach Anspruch 10, dadurch gekennzeichnet, dass zur Steuerung der Beleuchtung der erstgenannten Stirnfläche (21) des Lichtleiters (16) Mittel zur Tastung der Lichtquelle (3) vorhanden sind.

18. Licht-Schreibkopf nach Anspruch 10, dadurch gekennzeichnet, dass zur Steuerung der Beleuchtung der erstgenannten Stirnfläche (21) des Lichtleiters (16) Mittel zur Veränderung der Lichtbrechung im Lichtleiter (16) vorhanden sind.

19. Licht-Schreibkopf nach Anspruch 10, dadurch gekennzeichnet, dass im Gehäuse (1) mehrere Lichtleiter unterschiedlicher Querabmessungen mit zugeordneter Lichtquelle nebeneinander angeordnet sind, und dass Mittel vorgesehen sind, um wahlweise einen der Lichtleiter in eine zum Aufliegen auf der lichtempfindlichen Schicht des photographischen Trägers bestimmte Lage zu bringen.

20. Licht-Schreibkopf nach Anspruch 9, dadurch gekennzeichnet, dass die Bodenfläche (8) des Gehäuses einen äusseren, zum Aufliegen auf dem photographischen Träger (12) ausgebildeten Bodenvorsprung (24) aufweist, der mit einer durchgehenden Oeffnung (25), z.B. einem Loch, versehen ist, welche durch eine im Innern des Gehäuses (1) angeordnete Lichtquelle (3) beleuchtet ist.

21. Licht-Schreibkopf nach Anspruch 20, dadurch gekennzeichnet, dass im Innern des Gehäuses (1) unmittelbar vor der Oeffnung (25) des Bodenvorsprungs (24) ein elektrisch steuerbarer, z.B. elektromagnetisch oder piezoelektrisch betätigbarer Verschluss (6) angeordnet ist.

22. Licht-Schreibkopf nach Anspruch 20 oder 21, dadurch gekennzeichnet, dass in die Oeffnung (25) ein lichtdurchlässiges Füllstück (26), z.B. ein Glasstück, eingesetzt ist, dessen äussere Stirnseite zusammen mit der Aussenfläche des Bodenvorsprungs (24) eine glatte Fläche bildet.

**Claims**

1. Light-writing head for lighting points or lines on a photographic bearer (12) in a drafting machine or on a co-ordinate table, having a means for producing an automatically-controlled relative movement between the writing head and the photographic bearer, in which a controllable lighting device (3,6,7;3,6,7,16) is arranged in a housing (1), and the housing (1) has a light outlet opening (11;16',25) lit by the lighting device (3,6,7;3, 6,7,16), which light outlet opening can be brought at least almost into contact with the light-sensitive layer (13) of the photographic bearer (12) and which light outlet opening has transverse dimensions corresponding to the points or lines to be lit, characterized in that the light outlet opening (11) is arranged in a single plane on the outer surface of a bottom wall (8) of the lighttight housing (1), that the light-source (3) of the lighting device (3,6,7) is arranged in a chamber of the housing (1) closed by a partition (2), and that the partition (2) has an apertured diaphragm (5).

2. Light-writing head according to Claim 1, characterized in that the bottom wall (8) is provided with an image mask (10) lit by the light source (3).

3. Light-writing head according to Claim 2, characterized in that the image mask (10) is a foil, for example a metal foil or a film, provided with a transparent region (11).

4. Light-writing head according to one of the Claims 1 to 3, characterized in that the apertured diaphragm (5) is fitted with a movable shutter controlled electrically, for example, electro-magnetically or piezo-electrically.

5. Light-writing head according to Claim 2, characterized in that means for keying the light source are available in order to control the illumination of the image mask (10).

6. Light-writing head according to Claim 2, characterized in that the image mask (10) has various transparent regions of different shape and/or size, and that means are provided to bring a desired one of the transparent regions into the beam of the light source (3).

7. Light-writing head according to Claim 6, characterized in that the image mask (10) is arranged to be slidable on the bottom surface of the housing (1).

8. Light-writing head according to Claim 6, characterized in that the housing (1) contains various light sources, to each of which one of the transparent regions of the image mask is assigned.

9. Light-writing head according to the preamble of Claim 1, characterized in that the light outlet opening (16',25) is arranged in a single plane on the end wall of a component (15,24) shaped to lie on the light-sensitive layer (13) of the photographic support (12).

10. Light-writing head according to Claim 9, characterized in that at least one light-conductor (16) is arranged in the housing (1), of which light-conductor one end surface (21) is illuminated by a lignt source (3) and which extends: with the tip of its other end surface (16') beyond the bottom wall (8) of the housing (1), in which the second-mentioned end surface (16') is shaped to lie on the light-sensitive layer of the photographic bearer (12).

11. Light-writing head according to Claim 10, characterized in that the light-conductor (16) is embedded in a holder forming the component (15), which is movable in a bearing in the lengthwise direction of the light-conductor (16) in the housing (1).

12. Light-writing head according to Claim 11, characterized in that the light-conductor (16) together with the holder (15) extends through an opening (17) in the bottom wall (8); and together with the holder (15) forms a common flat and smooth end surface (16',22).

13. Light-writing head according to Claim 11 or 12, characterized in that the bearing for the holder (15) includes a guide (18) and a spring (20) pressing the holder (15) towards the outside of the housing (1).

14. Light-writing head according to Claim 10, characterized in that the first-mentioned end surface (21) of the lightconductor (16) lies inside the housing (1) and is illuminated by a light source (3) arranged also inside the housing (1) through a converging lens (14)

15. Light-writing head according to Claim 14, characterized in that between the light source (3) and the end surface (21) of the light-conductor (16) a movable shutter is arranged, controllable electrically, for example electromagnetically or piezo-electrically.

16. Light-writing head according to Claim 10, characterized in that the light source (3) is arranged in a fixed position outside the housing (1) and that the light-conductor extending outside the housing (1) to the light source (3) is flexible.

17. Light-writing head according to Claim 10, characterized in that for the control of the illumination of the first-mentioned end surface (21) of the light-conductor (16) means are provided for keying the light source (3).

18. Light-writing head according to Claim 10, characterized in that for the control of the illumination of the firstmentioned end-surface (21) of the light conductor (16), means are provided for varying the refraction of the light in the light-conductor (16).

19. Light-writing head according to Claim 10, characterized in that in the housing (1) various light-conductors of different transverse dimensions with assigned light sources are arranged side by side, and that means are provided to bring a chosen one of the light-conductors into a particular position so as to lie on the light-sensitive coating of the photographic bearer.

20. Light-writing head according to Claim 9, characterized in that the bottom surface (8) of the housing (1) has an outer built-out bottom projection (24) to lie on the photographic bearer (12), which projection (24) has a through opening (25), for example, a hole, which is illuminated by a light source (3) arranged inside the housing (1).

21. Light-writing head according to Claim 20, characterized in that inside the housing (1), immediately in front of the opening (25) of the bottom projection (24), a movable shutter (6) is arranged which is electrically controllable, for example, electro-magnetically or piezo-electrically.

22. Light-writing head according to Claim 20 or 21, characterized in that in the opening (25) a transparent filling piece (26) for example, a glass piece, is inserted, the outer side of which forms a smooth surface together with the outer surface of the bottom projection (24).

**Revendications**

1. Tête d'écriture à faisceau lumineux pour l'impression de points ou de lignes sur un support photographique (12) dans un appareil à dessiner ou un traceur de courbes, qui comporte des moyens pour provoquer un mouvement relatif commandé automatiquement entre la tête d'écriture et le support photographique (12), un dispositif d'éclairement (3,6,7; 3,6,7,16) réglable étant placé dans un boîtier (1) et le boîtier (1) comportant une ouverture de sortie de la lumière (11; 16',25) éclairée par le dispositif d'éclairement (3,6,7; 3,6,7,16), qui peut être amenée au moins approximativement au contact d'une couche photosensible (13) du support photographique (12) et qui présente des dimensions transversales correspondant aux points ou aux lignes à éclairer ou impressionner, caractérisée en ce que l'ouverture de sortie de la lumière (11) est placée dans un seul plan sur la surface extérieure d'une paroi de fond (8) du boîtier (1) étanche à la lumière, en ce que la source lumineuse (3) du dispositif d'éclairement (3,6,7) est placée dans une chambre du boîtier (1) fermée par une paroi de séparation (2), et en ce que la paroi de séparation (2) comporte un écran perforé (5).

2. Tête d'écriture selon la revendication 1, caractérisée en ce que la paroi de fond (8) comporte un masque d'image (10) éclairé par la source lumineuse (3).

3. Tête d'écriture selon la revendication 2, caractérisée en ce que le masque (10) est une feuille, par exemple une feuille métallique ou une pellicule, pourvue d'une zone transparente à la lumière (11).

4. Tête d'écriture selon l'une quelconque des revendications 1 à 3, caractérisée en ce qu'un obturateur (6) pouvant être commandé électriquement, par exemple à actionnement électromagnétique ou piézo-électrique, est associé au diaphragme (5).

5. Tête d'écriture selon la revendication 2, caractérisée en ce qu'on prévoit des moyens de modulation de la source lumineuse pour régler l'éclairage du masque (10).

6. Tête d'impression selon la revendication 2, caractérisée en ce que le masque (10) comporte plusieurs zones transparentes de formes et/ou grandeurs différentes, et en ce que des moyens sont présents pour amener à volonté l'une des zones transparentes dans le faisceau lumineux de la source lumineuse (3).

7. Tête d'écriture selon la revendication 6, caractérisée en ce que le masque d'image (10) est placé de façon à pouvoir être déplacé sur la surface de fond du boîtier (1).

8. Tête d'écriture selon la revendication 6, caractérisée en ce que le boîtier (1) contient plusieurs sources lumineuses dont chacune correspond à l'une des zones transparentes du masque (10).

9. Tête d'écriture selon le préambule de la revendication 1, caractérisée en ce que l'ouverture de sortie de la lumière (16', 25) est placée dans un seul plan sur la face frontale d'un composant (15, 24) conformé pour reposer sur la couche photosensible (13) du support photographique (12), et en ce que le boîtier (1) est étanche à la lumière.

10. Tête d'écriture selon la revendication 9, caractérisée en ce que le boîtier (1) contient au moins un guide de lumière (16) dont une face frontale (21) est éclairée par une source lumineuse (3) et qui dépasse, par son extrémité comportant l'autre face frontale (16'), de la paroi de fond (8) du boîtier (1), la face frontale (16') mentionnée en second lieu étant conformée pour reposer sur la couche photosensible (13) du support photographique (12).

11. Tête d'écriture selon la revendication 10, caractérisée en ce que le guide de lumière (16) est inséré dans un support (15) constituant le composant, placé dans le boîtier (1) de façon à être mobile dans la direction de la longueur du guide de lumière (16).

12. Tête d'écriture selon la revendication 11, caractérisée en ce que le guide de lumière (16) dépasse, avec le support (15), par une ouverture (17) de la paroi de fond (8) et forme, avec le support (15), une face frontale commune plane et lisse (16', 22).

13. Tête d'écriture selon la revendication 11 ou 12, caractérisée en ce que l'appui du support (15) comprend une glissière (18) et un ressort (20) exerçant sur le support (15) une pression vers l'extérieur du boîtier (1).

14. Tête d'écriture selon la revendication 10, caractérisée en ce que la face frontale mentionnée en premier lieu (21) du guide de lumière (16) se trouve à l'intérieur du boîtier (1) et peut être éclairée par une source lumineuse (3) placée également à l'intérieur du boîtier (1), par l'intermédiaire d'une lentille convergente (14).

15. Tête d'écriture selon la revendication 14, caractérisée en ce qu'un obturateur (6) pouvant être commandé électriquement, par exemple à actionnement électromagnétique ou piézo-électrique, est placé entre la source lumineuse (3) et la face frontale (21) du guide de lumière (16).

16. Tête d'écriture selon la revendication 10, caractérisée en ce que la source lumineuse (3) est placée fixement à l'extérieur du boîtier (1), et en ce que le guide de lumière s'étendant à l'extérieur du boîtier (1) jusqu'à la source lumineuse (3) est flexible.

17. Tête d'écriture selon la revendication 10, caractérisée en ce que des moyens de modulation de la source lumineuse (3) sont présents pour régler l'éclairage de la face frontale (21) mentionnée en premier lieu du guide de lumière (16).

18. Tête d'écriture selon la revendication 10, caractérisée en ce que des moyens de modification de l'indice de réfraction dans le guide de lumière (16) sont présents pour régler l'éclairage de la face frontale (21) du guide de lumière (16) mentionnée en premier lieu.

19. Tête d'écriture selon la revendication 10, caractérisée en ce que le boîtier (1) contient plusieurs guides de lumière de dimensions transversales différentes contigüs auxquels est rattachée une source lumineuse, et en ce que des moyens sont prévus pour amener à volonté l'un des guides de lumière dans une position déterminée au-dessus de la couche photosensible du support photographique.

20. Tête d'écriture selon la revendication 9, caractérisée en ce que la surface de fond (8) du boîtier (1) comporte une saillie de fond (24) extérieure, conformée pour être placée sur le support photographique (12) munie d'une ouverture traversante (25), par exemple un trou et qui est éclairée par une source lumineuse (3) placée à l'intérieur du boîtier (1).

21. Tête d'écriture selon la revendication 20, caractérisée en ce qu'un obturateur (6) pouvant être commandé électriquement, par exemple à actionnement électromagnétique ou piézo-électrique, est placé à l'intérieur du boîtier (1), juste avant l'ouverture (25) de la saillie de fond (24).

22. Tête d'écriture selon la revendication 20 ou 21, caractérisée en ce qu'une pièce de remplissage transparente (26), par exemple une pièce de verre, dont la face frontale extérieure forme une surface lisse avec la surface extérieure de la saillie de fond (24), est introduite dans l'ouverture (25).

Fig.1  Fig.2  Fig. 3